(19) Europäisches Patentamt / European Patent Office / Office européen des brevets

(11) **EP 3 439 142 B1**

(12) **FASCICULE DE BREVET EUROPEEN**

(45) Date de publication et mention
de la délivrance du brevet:
**11.03.2020 Bulletin 2020/11**

(51) Int Cl.:
***H02J 50/05*** ***(2016.01)***

(21) Numéro de dépôt: **18186415.8**

(22) Date de dépôt: **30.07.2018**

(54) **DISPOSITIF DE COUPLAGE À ISOLATION GALVANIQUE**

KUPPLUNGSVORRICHTUNG MIT GALVANISCHER ISOLIERUNG

COUPLING DEVICE WITH GALVANIC ISOLATION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **03.08.2017 FR 1757469**

(43) Date de publication de la demande:
**06.02.2019 Bulletin 2019/06**

(73) Titulaire: **Commissariat à l'Energie Atomique et
aux Energies
Alternatives
75015 Paris (FR)**

(72) Inventeurs:
• **GALISULTANOV, Ayrat
38000 GRENOBLE (FR)**
• **FANET, Hervé
38420 REVEL (FR)**
• **PERRIN, Yann
38000 GRENOBLE (FR)**
• **PILLONNET, Gaël
38120 PROVEYSIEUX (FR)**

(74) Mandataire: **Cabinet Beaumont
4, Place Robert Schuman
B.P. 1529
38025 Grenoble Cedex 1 (FR)**

(56) Documents cités:
**EP-A1- 3 182 590       JP-A- 2007 236 182
US-A1- 2006 018 082       US-A1- 2014 225 793**

EP 3 439 142 B1

**Description**

Domaine

La présente demande concerne le domaine des circuits électriques et électroniques de façon générale, et vise plus particulièrement un dispositif de couplage à isolation galvanique.

Exposé de l'art antérieur

Un dispositif de couplage à isolation galvanique est un dispositif permettant de transmettre des signaux électriques de donnée ou d'alimentation entre deux circuits électriques ou électroniques non reliés directement l'un à l'autre par un élément conducteur.

Parmi les dispositifs de couplage à isolation galvanique connus, on peut citer les transformateurs magnétiques, les condensateurs de couplage, les transformateurs piézoélectriques, et les opto-coupleurs.

Les dispositifs de couplage à isolation galvanique connus présentent toutefois certaines limitations. En particulier, dans un transformateur magnétique, il faut faire un compromis entre le coefficient de couplage entre les signaux d'entrée et de sortie, le taux d'isolation (c'est-à-dire la capacité à supporter des niveaux de tension différents entre le circuit d'entrée et le circuit de sortie), et les capacités parasites entre les spires des enroulements primaire et secondaire du transformateur. Dans le cas où l'isolation galvanique est réalisée par des capacités de couplage, un compromis doit être trouvé entre la vitesse de transmission des signaux et l'immunité aux modes communs du primaire et du secondaire. Un opto-coupleur permet quant à lui de ne pas avoir de capacités parasites entre primaire et secondaire mais présente l'inconvénient de ne pas être bidirectionnel. Les transformateurs piézoélectriques ont pour inconvénients d'être relativement coûteux, et d'avoir un taux d'isolation relativement faible du fait de la faible tenue en tension des matériaux piézoélectriques. Un exemple de dispositif de couplage capacitif utilisant une capacité variable peut être trouvé dans le document JP2007 236182.

Il serait donc souhaitable de pouvoir disposer d'une solution alternative aux dispositifs de couplage à isolation galvanique connus.

Résumé

Ainsi, un mode de réalisation prévoit un système comprenant des premier et deuxième circuits électriques ou électroniques isolés galvaniquement l'un de l'autre, et un dispositif de couplage reliant le premier circuit au deuxième circuit, le dispositif de couplage comprenant un condensateur à capacité variable comprenant des première et deuxième électrodes mobiles l'une par rapport à l'autre, séparées par une région isolante, et des troisième et quatrième électrodes isolées électriquement des première et deuxième électrodes, adaptées à recevoir un signal de commande pour faire varier, par un mécanisme d'actionnement électrostatique, électromagnétique ou piézoélectrique, la position relative des première et deuxième électrodes, de façon à faire varier la capacité entre les première et deuxième électrodes.

Selon un mode de réalisation, le dispositif de couplage comprend des première et deuxième bornes d'entrée connectées au premier circuit et adaptées à recevoir un signal d'entrée provenant du premier circuit, et des première et deuxième bornes de sortie connectées au deuxième circuit et isolées galvaniquement des première et deuxième bornes d'entrée, adaptées à fournir au deuxième circuit un signal de sortie image du signal d'entrée.

Selon l'invention, les première et deuxième bornes d'entrée sont connectées respectivement aux troisième et quatrième électrodes du condensateur.

Selon un mode de réalisation, les première et deuxième bornes de sortie sont reliées aux première et deuxième électrodes du condensateur de façon que le signal de sortie varie en fonction de la valeur de la capacité entre les première et deuxième électrodes.

Selon un mode de réalisation, le signal d'entrée est un signal alternatif, le dispositif de couplage comprenant un circuit adapté à appliquer une tension constante entre les première et deuxième électrodes du condensateur, et à fournir une tension proportionnelle au courant produit sur la deuxième électrode du condensateur du fait des variations de la capacité entre les première et deuxième électrodes du condensateur.

Selon un mode de réalisation, le circuit du dispositif de couplage comprend :

une source de tension adaptée à appliquer une première tension continue constante sur la première électrode du condensateur ;
un amplificateur opérationnel dont l'entrée négative est connectée à la deuxième électrode du condensateur ;
une source de tension adaptée à appliquer une deuxième tension continue constante sur l'entrée positive de l'amplificateur opérationnel ; et
une résistance reliant l'entrée négative de l'amplificateur opérationnel à la sortie de l'amplificateur opérationnel.

Selon un mode de réalisation, le signal d'entrée est un signal alternatif ou continu, le dispositif de couplage comprenant un oscillateur adapté à fournir une tension dont la fréquence est fonction de la valeur de la capacité entre les première et deuxième électrodes du condensateur.

Selon un mode de réalisation, l'oscillateur comprend un comparateur à hystérésis agencé pour comparer la tension entre les première et deuxième électrodes du condensateur à un premier seuil et à un deuxième seuil inférieur au premier seuil, et à commander l'application d'un courant de décharge constant entre les première et deuxième électrodes du condensateur lorsque ladite tension atteint le premier seuil, et l'application d'un courant de charge constant entre les première et deuxième électrodes du condensateur lorsque ladite tension atteint le deuxième seuil.

Selon un mode de réalisation, le dispositif de couplage comprend en outre :

un condensateur supplémentaire à capacité variable comprenant des première et deuxième électrodes mobiles l'une par rapport à l'autre, séparées par une région isolante, et des troisième et quatrième électrodes isolées électriquement des première et deuxième électrodes, adaptées à recevoir un signal de commande pour faire varier, par un mécanisme d'actionnement électrostatique, électromagnétique ou piézoélectrique, la position relative des première et deuxième électrodes de façon à faire varier la capacité entre ses première et deuxième électrodes ;
une source de tension adaptée à appliquer une tension continue de référence entre les troisième et quatrième électrodes du condensateur supplémentaire ;
un oscillateur supplémentaire adapté à fournir une tension dont la fréquence est fonction de la valeur de la capacité entre les première et deuxième électrodes du condensateur supplémentaire ; et
une boucle à verrouillage de phase adaptée à fournir un signal représentatif de la différence de fréquence entre la tension fournie par l'oscillateur et la tension fournie par l'oscillateur supplémentaire.

Selon un mode de réalisation, le premier circuit est alimenté sous une tension au moins dix fois plus faible ou au moins dix fois plus élevée que le deuxième circuit.

Selon un mode de réalisation, les première, deuxième, troisième et quatrième électrodes du condensateur sont revêtues d'une couche en un matériau isolant.

Selon un mode de réalisation, le matériau isolant est du parylène.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est un schéma électrique d'un condensateur à capacité variable à quatre électrodes ;
la figure 2 est une vue en coupe schématique d'un exemple de réalisation d'un condensateur à capacité variable à quatre électrodes à actionnement électrostatique ;
la figure 3 est une vue en coupe schématique d'un exemple de réalisation d'un condensateur à capacité variable à quatre électrodes à actionnement électromagnétique ;
la figure 4 est un schéma électrique d'un exemple d'un dispositif de couplage à isolation galvanique selon un mode de réalisation ;
la figure 5 est un schéma électrique d'un autre exemple d'un dispositif de couplage à isolation galvanique selon un mode de réalisation ;
la figure 6 est un schéma électrique illustrant plus en détail un exemple de réalisation d'un oscillateur du dispositif de couplage à isolation galvanique de la figure 5 ; et
la figure 7 est un schéma électrique d'un autre exemple d'un dispositif de couplage à isolation galvanique selon un mode de réalisation.

Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, les circuits électriques ou électroniques susceptibles d'être reliés entre eux par les dispositifs de couplage à isolation galvanique décrits n'ont pas été détaillés, les dispositifs de couplage décrits pouvant être utilisés dans tout système comprenant deux circuits électriques ou électroniques non connectés l'un à l'autre, c'est-à-dire non reliés directement par un élément conducteur, par exemple deux circuits alimentés par des tensions de niveaux distincts et ayant des bornes de référence ou masses distinctes, pour transmettre des signaux électriques de données ou d'alimentation entre les deux circuits. A titre d'exemple, les dispositifs de couplage à isolation galvanique décrits ci-après peuvent être utilisés pour commander des composants électroniques de puissance tels que des transistors, thyristors, triacs, etc., ou pour réaliser un circuit d'alimentation isolé. Dans la description qui suit, lorsque l'on fait référence à des qualificatifs de position relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près.

La demande de brevet européen N°16204534.8 (B14590/DD16568), déposée le 15 décembre 2016, décrit des exemples de réalisation de circuits logiques à base de condensateurs à capacité variable électromécaniques comportant deux électrodes principales séparées par une région isolante, et deux électrodes de commande isolées électriquement des électrodes principales et adaptées à recevoir un signal de commande pour faire varier la capacité entre les électrodes principales.

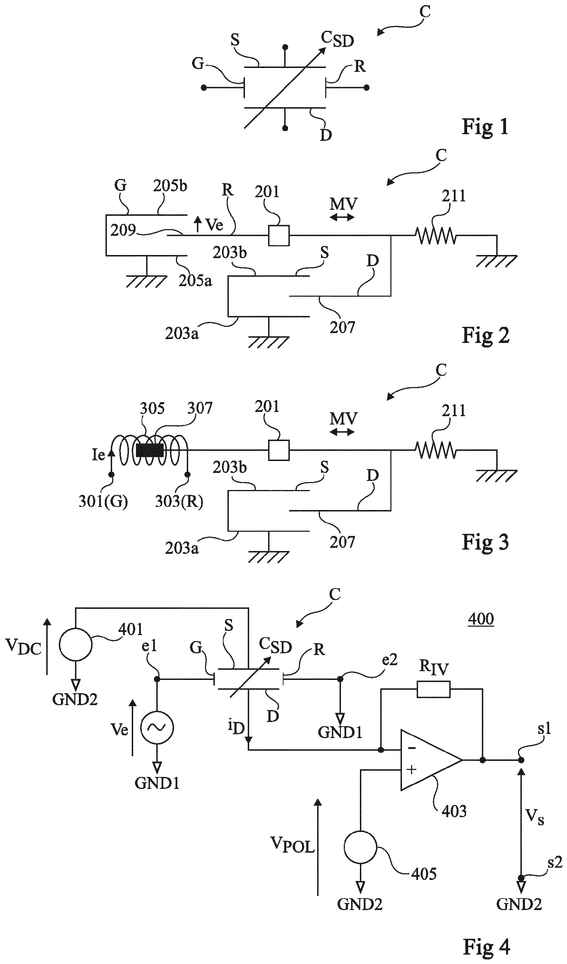

La figure 1 est un schéma électrique d'un tel condensateur, désigné par la référence C sur la figure. Sur la figure 1, les électrodes principales sont désignées par les références S et D, et les électrodes de commande sont désignées par les références R et G. Les électrodes principales S et D sont mobiles l'une par rapport à l'autre, et la capacité $C_{SD}$ entre les électrodes principales S et D est fonction de la position relative des électrodes S et D. Le signal de commande appliqué entre les électrodes R et G permet de faire varier la position relative des électrodes S et D, de façon à faire varier la capacité $C_{SD}$. L'actionnement du condensateur C peut être de type électrostatique, tel que décrit par exemple en relation avec les figures 16A, 16B, 17A, 17B et 18 de la demande de brevet européen N°16204534.8 susmentionnée, ou électromagnétique tel que décrit par exemple en relation avec la figure 19 de la demande de brevet européen N°16204534.8 susmentionnée.

D'autres exemples de réalisation de condensateurs à capacité variable à quatre électrodes à actionnement électrostatique ou électromagnétique sont décrits dans la demande de brevet français N°17/55419 (B15834/DD17806) déposée le 15 juin 2017. Ces condensateurs ont notamment pour particularité que pour au moins une configuration du condensateur, la valeur de la capacité $C_{SD}$ formée entre les électrodes principales S et D du condensateur est indépendante de la tension $V_{SD}$ appliquée entre lesdites électrodes principales. Pour cela, le condensateur comprend un système de contrôle de la position de l'électrode D par rapport à l'électrode S, ce système étant agencé pour que, pour au moins une position relative de l'électrode D par rapport à l'électrode S, la position de l'électrode D par rapport à l'électrode S soit indépendante de la tension $V_{SD}$ appliquée entre les électrodes S et D. A titre d'exemple, l'électrode S comprend deux premières plaques conductrices sensiblement parallèles entre elles et connectées électriquement l'une à l'autre, et l'électrode D comprend une deuxième plaque conductrice sensiblement parallèle aux premières plaques conductrices et disposée entre les premières plaques conductrices, et le système de contrôle est un système électrostatique tel que, pour au moins une position de l'électrode D par rapport à l'électrode S, la force électrostatique exercée sur la deuxième plaque conductrice par l'une des premières plaques conductrices compense la force électrostatique exercée sur la deuxième plaque conductrice par l'autre première plaque conductrice.

Des exemples de condensateurs à capacité variable à quatre électrodes à actionnement électrostatique sont en outre décrits dans la demande de brevet EP0986077 et dans la demande de brevet correspondante US6242989.

Selon un aspect d'un mode de réalisation, on prévoit de réaliser un dispositif de couplage à isolation galvanique à partir d'un condensateur à capacité variable électromécanique à quatre électrodes, à actionnement électrostatique ou électromagnétique. Plus particulièrement, on tire ici profit du fait que la valeur de la capacité $C_{SD}$ entre les électrodes principales S et D est fonction d'un signal de commande appliqué entre les électrodes de commande G et R, et que les électrodes S et D sont isolées électriquement des électrodes G et R, pour réaliser un dispositif de couplage à isolation galvanique.

La figure 2 est une vue en coupe schématique d'un exemple de réalisation d'un condensateur C à capacité variable à quatre électrodes à actionnement électrostatique pouvant être utilisé pour réaliser un dispositif de couplage à isolation galvanique.

Le condensateur C comprend deux ensembles mobiles l'un par rapport à l'autre, appelés ci-après respectivement ensemble fixe et ensemble mobile. Tous les éléments de l'ensemble fixe sont fixes les uns par rapport aux autres, et tous les éléments de l'ensemble mobile sont fixes les uns par rapport aux autres. Sur la figure 2, on a représenté par des hachures obliques une masse mécanique, à laquelle sont fixés tous les éléments de l'ensemble fixe.

Dans l'exemple de la figure 2, les électrodes S et G font partie de l'ensemble fixe, et les électrodes D et R font partie de l'ensemble mobile. Le carré référencé 201 sur la figure 3 schématise une région électriquement isolante de l'ensemble mobile, isolant électriquement l'électrode D de l'électrode R.

L'électrode S comprend deux plaques conductrices 203a et 203b sensiblement horizontales et en vis-à-vis l'une de l'autre (c'est-à-dire sensiblement confondues en projection verticale), solidaires mécaniquement l'une de l'autre et connectées électriquement l'une à l'autre. L'électrode G comprend deux plaques conductrices 205a et 205b sensiblement horizontales et en vis-à-vis l'une de l'autre, solidaires mécaniquement l'une de l'autre et connectées électriquement l'une à l'autre mais isolées électriquement des plaques conductrices 203a et 203b. L'électrode D comprend une plaque conductrice 207 sensiblement horizontale, isolée électriquement des plaques conductrices 203a, 203b, 205a et 205b et mobile par rapport aux plaques conductrices 203a, 203b, 205a et 205b. L'électrode R comprend une plaque conductrice 209 sensiblement horizontale, solidaire mécaniquement de la plaque conductrice 207 mais isolée électriquement de la plaque 207 par la région d'isolation 201. On notera que dans la présente description, on entend par plaque conductrice une plaque en un matériau apte à conduire des charges électriques, ce matériau pouvant être un matériau conducteur, par exemple un métal, ou encore un matériau semiconducteur, par exemple du silicium.

Dans cet exemple, l'ensemble fixe et l'ensemble mobile sont agencés de façon que les plaques conductrices 207 et 209 soient disposées respectivement :

entre les plaques conductrices 203a et 203b, au moins partiellement en vis-à-vis des plaques conductrices 203a et 203b, sensiblement à équidistance des plaques conductrices 203a et 203b ; et
entre les plaques conductrices 205a et 205b, au moins partiellement en vis-à-vis des plaques conductrices 205a et 205b, sensiblement à équidistance des plaques conductrices 205a et 205b.

Dans cet exemple, l'ensemble mobile est libre de se déplacer selon un unique degré de liberté en translation horizontale (parallèlement aux plaques conductrices 203a, 203b, 207, 205a, 205b, 209) par rapport à l'ensemble fixe, de façon à modifier la surface de la plaque conductrice mobile 207, respectivement 209 en vis-à-vis des plaques conductrices fixes correspondantes 203a et 203b, respectivement 205a et 205b, sans modifier la distance entre chaque plaque conductrice mobile et les plaques conductrices fixes correspondantes (mouvement représenté par une double flèche MV sur la figure). Plus particulièrement, dans l'exemple de la figure 2, l'ensemble fixe et l'ensemble mobile sont agencés de façon que lorsque la surface de l'une quelconque des plaques conductrices mobiles 207 et 209 en vis-à-vis des plaques conductrices fixes correspondantes 203a et 203b, respectivement 205a et 205b augmente, la surface de l'autre plaque conductrice mobile en vis-à-vis des plaques conductrices fixes correspondantes augmente, et inversement.

Le condensateur C de la figure 2 comporte en outre un moyen de rappel, par exemple un ressort de rappel 211 reliant l'ensemble mobile à l'ensemble fixe, agencé pour, en l'absence de toute polarisation électrique des électrodes, ramener l'ensemble mobile dans une position (par rapport à l'ensemble fixe) dite de repos, par exemple une position dans laquelle les plaques conductrices mobiles 207 et 209 sont seulement partiellement en vis-à-vis des plaques conductrices fixes correspondantes 203a et 203b, respectivement 205a et 205b (par exemple la position représentée sur la figure 2).

Au premier ordre, la capacité $C_{SD}$ du condensateur C entre ses électrodes principales S et D est proportionnelle à la surface de la plaque conductrice 207 en vis-à-vis des plaques conductrices 203a et 203b.

Lorsqu'une tension Ve non nulle est appliquée entre les électrodes de commande G et R du condensateur, la plaque conductrice mobile 209 est attirée entre les plaques conductrices fixes correspondantes 205a et 205b par interaction électrostatique. Ceci entraine un déplacement horizontal de l'ensemble mobile par rapport à l'ensemble fixe, tendant à augmenter la surface de la plaque conductrice mobile 209 en vis-à-vis des plaques conductrices fixes correspondantes 205a et 205b, et par conséquent la surface de la plaque conductrice mobile 207 en vis-à-vis des plaques conductrices fixes 203a et 203b. La capacité $C_{SD}$ du condensateur C tend ainsi à augmenter. Une diminution (en valeur absolue) de la tension de commande appliquée entre les électrodes G et R conduit au contraire à ramener l'ensemble mobile vers sa position de repos, et donc à ramener la capacité $C_{SD}$ vers sa valeur initiale.

La figure 3 est une vue en coupe schématique d'un exemple de réalisation d'un condensateur C à capacité variable à quatre électrodes à actionnement électromagnétique pouvant être utilisé pour réaliser un dispositif de couplage à isolation galvanique.

Le condensateur C de la figure 3 diffère du condensateur C de la figure 2 principalement en ce que, dans l'exemple de la figure 3, les plaques conductrices 205a, 205b et 209 sont remplacées par un ensemble comprenant :

une borne conductrice 301, correspondant à l'électrode G du condensateur ;
une borne conductrice 303, correspondant à l'électrode R du condensateur ;
une bobine conductrice 305 dont une première extrémité est connectée électriquement à la borne 301 et dont une deuxième extrémité est connectée électriquement à la borne 303 ; et
un aimant 307 disposé à l'intérieur de la bobine 305.

Dans cet exemple, les bornes 301 et 303 et la bobine 305 font partie de l'ensemble fixe du condensateur, et l'aimant 307 est un élément de l'ensemble mobile du condensateur. Autrement dit, les bornes 301 et 303 et la bobine 305 sont fixes par rapport aux plaques conductrices 301a, 301b, 305a et 305b, et l'aimant 307 est fixe par rapport à la plaque conductrice 207. L'aimant 307 est par exemple (mais non nécessairement) isolé électriquement de la plaque conductrice 207. Dans cet exemple, l'axe central de la bobine 305 est sensiblement horizontal.

L'application d'un courant de commande Ie dans la bobine 305 par l'intermédiaire des électrodes G et R entraine un déplacement de l'aimant 307 le long de l'axe central de la bobine. Il en résulte une variation de la surface de la plaque conductrice mobile 207 en vis-à-vis des plaques conductrices fixes 203a et 203b, et donc une variation de la capacité C$_{SD}$ du condensateur C.

Plus généralement, d'autres structures de condensateurs à capacité variable à quatre électrodes à actionnement électrostatique ou électromagnétique, par exemple des structures du type décrites dans les demandes de brevet européen N°16204534.8 et français N°17/55419 susmentionnées, peuvent être utilisées pour réaliser un dispositif de couplage à isolation galvanique.

De préférence, et bien que cela ne soit pas détaillé sur les figures 2 et 3, chacune des quatre électrodes du condensateur est revêtue d'une couche protectrice en un matériau isolant, par exemple un polymère isolant, par exemple du parylène. A titre d'exemple, le matériau isolant est pulvérisé sur toutes les parties conductrices du condensateur C et notamment sur ses électrodes à la fin du procédé de fabrication du condensateur. Ceci permet d'augmenter la tenue en tension du condensateur, dans la mesure où la tension de claquage du matériau isolant est supérieure à celle de l'air.

La figure 4 est un schéma électrique d'un exemple d'un dispositif de couplage à isolation galvanique 400 selon un mode de réalisation.

Le dispositif de la figure 4 comprend un condensateur à capacité variable à quatre électrodes à actionnement électrostatique, par exemple un condensateur du type décrit en relation avec la figure 2.

Le dispositif de couplage de la figure 4 est adapté à recevoir une tension alternative d'entrée Ve appliquée entre des bornes d'entrée e1 et e2 du dispositif, et à fournir une tension alternative de sortie Vs image de la tension Ve, entre des bornes de sortie s1 et s2 du dispositif. Les bornes d'entrée e1 et e2 sont isolées galvaniquement des bornes de sortie s1 et s2, c'est-à-dire qu'il n'existe pas de liaison conductrice entre elles. A titre d'exemple, la tension Ve est fournie par un premier circuit électrique ou électronique (non représenté sur la figure) connecté aux bornes d'entrée e1 et e2 du dispositif de couplage, et la tension Vs est appliquée à un deuxième circuit électrique ou électronique (non représenté sur la figure) connecté aux bornes de sortie du dispositif de couplage, aucune liaison conductrice n'étant prévue entre les premier et deuxième circuits. A titre d'exemple, les premier et deuxième circuits sont alimentés par des tensions de niveaux distincts et ont des bornes de référence ou masses distinctes.

Dans cet exemple, les bornes d'entrée e1 et e2 du dispositif de couplage sont connectées respectivement aux électrodes G et R du condensateur C. A titre d'exemple, la borne e2 est connectée à une borne GND1 d'application d'un potentiel de référence du premier circuit, par exemple la masse du premier circuit, la tension d'entrée Ve délivrée par le premier circuit étant référencée par rapport à la borne GND1.

Le dispositif de couplage de la figure 4 comprend un circuit adapté à fixer à une valeur constante la tension entre les électrodes S et D du condensateur C, et à fournir une tension Vs proportionnelle au courant entre les électrodes S et D du condensateur.

Plus particulièrement, dans cet exemple, le dispositif de couplage comprend une première source de tension continue 401 appliquant une tension constante V$_{DC}$ sur l'électrode S du condensateur C. La tension V$_{DC}$ est référencée par rapport à une borne GND2 d'application d'un potentiel de référence du deuxième circuit, par exemple la masse du deuxième circuit. Le dispositif de couplage de la figure 4 comprend en outre un amplificateur opérationnel 403 ayant une borne d'entrée négative (-) connectée à l'électrode D du condensateur C, et une borne d'entrée positive (+) . Le dispositif de couplage de la figure 4 comprend de plus une deuxième source de tension continue 405 appliquant une tension constante V$_{POL}$ sur la borne d'entrée positive (+) de l'amplificateur opérationnel 403. La tension V$_{POL}$ est référencée par rapport à la borne GND2. Le dispositif de couplage de la figure 4 comprend en outre une résistance R$_{IV}$ reliant l'entrée négative (-) de l'amplificateur opérationnel 403 à un noeud de sortie de l'amplificateur opérationnel 403. Les bornes de sortie s1 et s2 du dispositif de couplage sont connectées respectivement à la borne de sortie de l'amplificateur opérationnel 403 et à la borne GND2. Autrement dit, la tension de sortie Vs du dispositif de couplage de la figure 4 est la tension de sortie de l'amplificateur opérationnel 403, référencée par rapport à la borne GND2.

Le fonctionnement du dispositif de couplage de la figure 4 est le suivant. Lorsqu'une tension alternative d'entrée Ve est appliquée entre des bornes d'entrée e1 et e2, la valeur de la capacité C$_{SD}$ entre les électrodes principales S et D du condensateur C suit les variations de la tension Ve. L'amplificateur opérationnel 403 permet de maintenir une tension de polarisation continue (la tension V$_{POL}$, référencée par rapport au noeud GND2) sur l'électrode D du condensateur C. Ainsi, la tension V$_{SD}$ entre les électrodes principales S et D du condensateur C est maintenue à une valeur constante, sensiblement égale à V$_{DC}$-V$_{POL}$. L'amplificateur opérationnel 403 permet en outre de convertir en tension le courant i$_D$ généré sur l'électrode D du condensateur C.

Le courant i$_D$ peut s'exprimer comme suit :

$$i_D = \left( C_{SD} \frac{dV_{SD}}{dt} \right)_{C_{SD}=cst} + \left( V_{SD} \frac{dC_{SD}(Ve)}{dt} \right)_{V_{SD}=V_{DC}-V_{POL}}$$

Le premier terme de l'équation ci-dessus peut être considéré comme nul, la tension V$_{SD}$ étant sensiblement constante. Le courant i$_D$ est alors lié uniquement à la variation temporelle de la capacité C$_{SD}$, elle-même liée à la variation temporelle de la tension d'entrée Ve. La tension de sortie Vs du dispositif de couplage est liée au courant $i_D$ par l'équation suivante :

$$V_s = R_{IV} * I_D = R_{IV} * V_{SD} \frac{dC_{SD}(Ve)}{dt}$$

La tension de sortie Vs du dispositif de couplage est donc une image de la tension d'entrée Ve. L'isolation galvanique est assurée par le condensateur à capacité variable à quatre électrodes, notamment via la région isolante séparant l'électrode D de l'électrode R (élément 201 de l'ensemble mobile dans l'exemple de la figure 2). Ainsi, la tension d'alimentation du circuit d'entrée (fournissant la tension Ve) peut être différente de la tension d'alimentation du circuit de sortie (recevant la tension Vs). A titre d'exemple, la tension d'alimentation du circuit d'entrée est au moins 10 fois plus élevée ou au moins 10 fois plus faible que la tension d'alimentation du circuit de sortie. De plus, les potentiels de référence présents sur la borne GND1 du circuit d'entrée et sur la borne GND2 du circuit de sortie peuvent être différents.

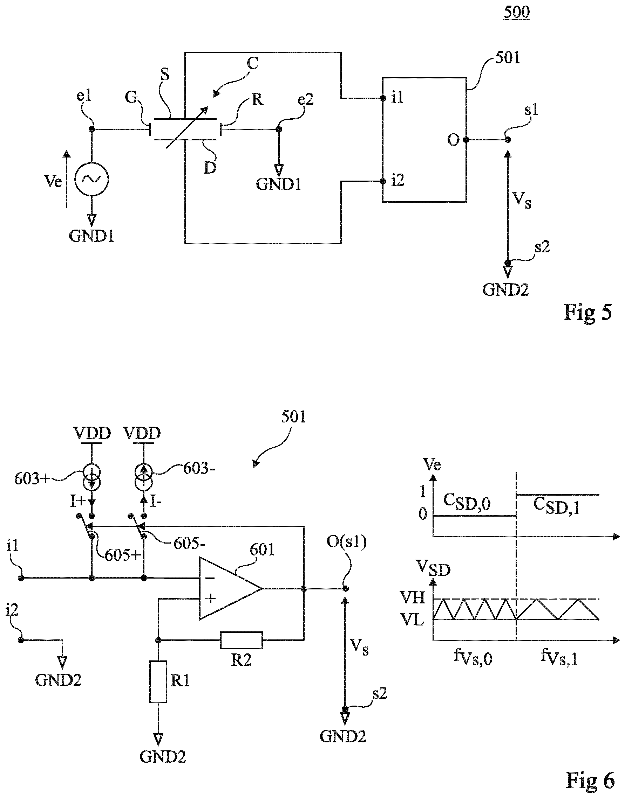

La figure 5 est un schéma électrique d'un autre exemple d'un dispositif de couplage à isolation galvanique 500 selon un mode de réalisation.

Le dispositif de la figure 5 comprend un condensateur à capacité variable à quatre électrodes à actionnement électrostatique C, par exemple un condensateur du type décrit en relation avec la figure 2.

Le dispositif de couplage de la figure 5 est adapté à recevoir une tension d'entrée Ve appliquée entre des bornes d'entrée e1 et e2 du dispositif, et à fournir une tension alternative de sortie Vs de fréquence $f_{Vs}$ représentative de la valeur de la tension d'entrée Ve, entre des bornes de sortie s1 et s2 du dispositif. On notera que dans l'exemple de la figure 5, la tension d'entrée Ve peut être une tension continue ou une tension alternative, ce qui constitue une différence par rapport au dispositif de couplage de la figure 4 qui permet de transmettre uniquement des signaux alternatifs.

Comme dans l'exemple de la figure 4, les bornes d'entrée e1 et e2 sont isolées galvaniquement des bornes de sortie s1 et s2. A titre d'exemple, la tension Ve est fournie par un premier circuit électrique ou électronique (non représenté sur la figure) connecté aux bornes d'entrée e1 et e2 du dispositif de couplage, et la tension Vs est appliquée à un deuxième circuit électrique ou électronique (non représenté sur la figure) connecté aux bornes de sortie du dispositif de couplage, aucune liaison conductrice n'étant prévue entre les premier et deuxième circuits. A titre d'exemple, les premier et deuxième circuits sont alimentés par des tensions de niveaux distincts et ont des bornes de référence ou masses distinctes.

Dans cet exemple, les bornes d'entrée e1 et e2 du dispositif de couplage sont connectées respectivement aux électrodes G et R du condensateur C. A titre d'exemple, la borne e2 est connectée à une borne GND1 d'application d'un potentiel de référence du premier circuit, par exemple la masse du premier circuit, la tension d'entrée Ve délivrée par le premier circuit étant référencée par rapport à la borne GND1.

Le dispositif de couplage de la figure 5 comprend un oscillateur 501, par exemple un oscillateur à relaxation, ayant deux bornes d'entrée i1 et i2 connectées respectivement aux électrodes principales S et D du condensateur C. L'oscillateur 501 utilise la capacité $C_{SD}$ pour osciller et fournit, sur une borne de sortie o connectée à la borne de sortie s1 du dispositif de couplage, une tension alternative périodique Vs dont la fréquence $f_{Vs}$ est fonction de la valeur de la capacité $C_{SD}$, et par conséquent de la valeur de la tension d'entrée Ve du dispositif de couplage. Dans cet exemple, la tension Vs est référencée par rapport à une borne GND2 d'application d'un potentiel de référence du deuxième circuit, par exemple la masse du deuxième circuit, la borne de sortie s2 du dispositif de couplage étant connectée à la borne GND2.

La figure 6 est un schéma électrique illustrant plus en détail un exemple de réalisation de l'oscillateur 501 du dispositif de couplage à isolation galvanique de la figure 5. La figure 6 comprend en outre, en partie droite, un chronogramme illustrant le fonctionnement de l'oscillateur 501.

L'oscillateur 501 de la figure 6 comprend un amplificateur opérationnel 601 dont une borne d'entrée négative (-) est connectée à la borne i1 de l'oscillateur, destinée à être connectée à l'électrode S du condensateur C. La borne i2 de l'oscillateur, destinée à être connectée à l'électrode D du condensateur C, est connectée à la borne de référence GND2. L'oscillateur 501 comprend en outre une résistance R1 reliant une borne d'entrée positive (+) de l'amplificateur 601 à la borne de référence GND2, et une résistance R2 reliant la borne d'entrée positive (+) de l'amplificateur 601 à une borne de sortie de l'amplificateur 601. Plus particulièrement, dans l'exemple représenté, la résistance R1 a une première extrémité connectée à la borne d'entrée positive (+) de l'amplificateur 601 et une deuxième extrémité connectée à la borne GND2, et la résistance R2 a une première extrémité connectée à la borne d'entrée positive (+) de l'amplificateur 601 et une deuxième extrémité connectée à la borne de sortie de l'amplificateur 601. La borne de sortie de l'amplificateur 601 est connectée à la borne de sortie o de l'oscillateur. L'oscillateur 501 de la figure 6 comprend de plus une première source de courant 603+ reliée à la borne i1 par un interrupteur 605+, et une deuxième source de courant 603- reliée à la borne i1 par un interrupteur 605-. La source de courant 603+ fournit un courant constant I+ d'une première polarité, adapté à charger la capacité $C_{SD}$ lorsque l'interrupteur 605+ est fermé (passant). La source de courant 603- fournit un courant constant I- de polarité opposée, par exemple de même intensité que le courant I+, adapté à décharger la capacité $C_{SD}$ lorsque l'interrupteur 605- est fermé (passant). Les interrupteurs 605+ et 605- sont commandés en opposition de phase en fonction du signal de sortie de l'amplificateur 601.

A titre d'exemple illustratif, on considère ici que le signal d'entrée du dispositif de couplage est un signal binaire, c'est-à-dire que la tension Ve peut prendre l'une ou l'autre de deux valeurs haute et basse, correspondant respectivement à la valeur binaire '1' et à la valeur binaire '0'. Ainsi, la capacité $C_{SD}$ du condensateur C peut prendre l'une ou l'autre de deux valeurs $C_{SD,1}$ et $C_{SD,0}$, correspondant respectivement à l'état haut et à l'état bas de la tension Ve. Dans l'exemple considéré, le condensateur C est un condensateur à variation de capacité positive, c'est-à-dire que la capacité $C_{SD,1}$ est supérieure à la capacité $C_{SD,0}$. Les modes de réalisation décrits peuvent toutefois aisément être adaptés au cas où le condensateur C est un condensateur à variation de capacité négative.

L'amplificateur 601 se comporte comme un comparateur à hystérésis commandant la charge ou la décharge de la capacité $C_{SD}$ par les sources de courants constants 603+ et 603-. Plus particulièrement, lorsque les interrupteurs 605+ et 605- sont respectivement fermé (passant) et ouvert (bloqué), la capacité $C_{SD}$ se charge sous l'effet du courant I+ fourni par la source de courant 603+. Lorsque la tension $V_{SD}$ atteint un seuil haut $V_H$ fixé notamment par les valeurs des résistances R1 et R2, le signal de sortie change d'état, provoquant l'ouverture de l'interrupteur 605+ et la fermeture de l'interrupteur 605-. La capacité $C_{SD}$ se décharge alors sous l'effet du courant I- fourni par la source de courant 603-. Lorsque la tension $V_{SD}$ atteint un seuil bas $V_L$ fixé notamment par les valeurs des résistances R1 et R2, le signal de sortie change d'état, provoquant la fermeture de l'interrupteur 605+ et l'ouverture de l'interrupteur 605-. Les courants I+ et I-étant constants, la fréquence d'oscillation $f_{Vs}$ du signal de sortie de l'amplificateur 601 est fonction de la valeur de la capacité $C_{SD}$, et donc de la valeur de la tension d'entrée Ve. Plus particulièrement, dans cet exemple, la fréquence du signal de sortie de l'oscillateur a une première valeur $f_{Vs,0}$ lorsque la tension Ve est à l'état bas, et une deuxième valeur $f_{Vs,1}$ inférieure à la première valeur lorsque la tension Ve est à l'état haut.

La tension de sortie Vs du dispositif de couplage est donc une image, codée en fréquence, de la tension d'entrée Ve. L'isolation galvanique est assurée par le condensateur à capacité variable à quatre électrodes, notamment via la région isolante séparant l'électrode D de l'électrode R (élément 201 de l'ensemble mobile dans l'exemple de la figure 2).

On notera que le mode de réalisation des figures 5 et 6 n'est pas limité à l'exemple représenté dans lequel la tension d'entrée Ve est un signal binaire, mais peut être adapté au cas où la tension d'entrée Ve est un signal analogique variable de façon continue ou variable par paliers avec un nombre de paliers supérieur à deux.

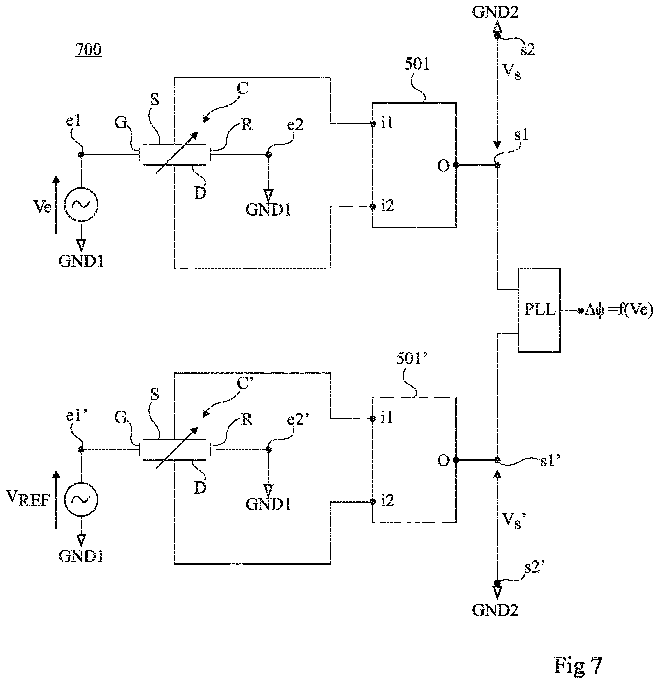

La figure 7 est un schéma électrique illustrant une variante de réalisation différentielle du dispositif de couplage à isolation galvanique de la figure 5.

Le dispositif de couplage 700 de la figure 7 comprend les mêmes éléments que le dispositif de couplage de la figure 5, agencés sensiblement de la même manière.

Le dispositif de couplage de la figure 7 comprend de plus un deuxième condensateur à capacité variable à quatre électrodes à actionnement électrostatique C', par exemple identique ou similaire au condensateur C.

Le dispositif de couplage de la figure 7 comprend de plus une source de tension 701 adaptée à recevoir une tension de référence $V_{REF}$, par exemple une tension continue de valeur constante, appliquée entre des bornes d'entrée e1' et e2' du dispositif, connectées respectivement aux électrodes G et R du condensateur C', et à fournir une tension alternative de sortie Vs' de fréquence $f_{Vs'}$ représentative de la valeur de la tension de référence $V_{REF}$, entre des bornes s1' et s2'. Les bornes d'entrée e1' et e2' sont isolées galvaniquement des bornes s1' et s2' d'une part, et des bornes s1 et s2 d'autre part. Dans cet exemple, la borne s2' du dispositif de couplage est connectée à la borne GND2.

Pour produire la tension Vs', le dispositif de couplage de la figure 7 comprend un deuxième oscillateur 501', identique ou similaire à l'oscillateur 501, dont les bornes i1 et i2 sont connectées respectivement aux électrodes S et D du condensateur C', et dont la borne de sortie o est connectée à la borne s1'.

Le dispositif de couplage de la figure 7 comprend de plus une boucle à verrouillage de phase PLL recevant en entrée les tensions Vs et Vs' et fournissant un signal de sortie $\Delta\phi$ représentatif de la différence de fréquence entre les signaux Vs et Vs', et donc de la valeur de la tension d'entrée Ve.

Dans cet exemple, le signal $\Delta\phi$ constitue le signal de sortie du dispositif de couplage.

Un avantage du dispositif de couplage de la figure 7 est qu'il est moins sensible à d'éventuelles perturbations parasites que le dispositif de couplage de la figure 5. En particulier, dans l'exemple de la figure 7, le signal de sortie $\Delta\phi$ est indépendant d'éventuelles fluctuations des potentiels de référence présents sur les bornes GND1 et GND2 des circuits d'entrée et de sortie du dispositif de couplage.

Des modes de réalisation particuliers ont été décrits. Diverses variantes et modifications apparaîtront à l'homme de l'art. En particulier, bien que les exemples de dispositifs de couplage des figures 4, 5, 6 et 7 soient basés sur des condensateurs à capacité variable à quatre électrodes à actionnement électrostatique, l'homme du métier saura adapter ces exemples pour réaliser un dispositif de couplage à partir d'un condensateur à capacité variable à quatre électrodes à actionnement électromagnétique, par exemple un condensateur du type décrit en relation avec la figure 3.

En outre, l'homme du métier saura adapter les exemples décrits pour réaliser un dispositif de couplage à partir d'un condensateur à capacité variable à quatre électrodes à actionnement piézoélectrique.

De plus, les modes de réalisation décrits ne se limitent pas aux exemples de dispositifs de couplage décrits en relation avec les figures 4, 5, 6 et 7. Plus généralement, l'homme du métier saura prévoir d'autres circuits basés sur un condensateur à capacité variable à quatre électrodes à actionnement électrostatique ou électromécanique pour réaliser un dispositif de couplage à isolation galvanique.

On notera de plus que bien que les exemples décrits en relation avec les figures 4, 5, 6 et 7 correspondent uniquement à des dispositifs de couplage adaptés à transmettre des signaux de commande entre deux circuits, les modes de réalisation décrits ne se limitent pas à ce cas particulier. L'homme du métier saura prévoir des dispositifs de couplage à isolation galvanique basés sur des condensateurs à capacité variable à quatre électrodes à actionnement électrostatique ou électromagnétique, permettant de transférer de l'énergie électrique entre deux circuits.

En outre, bien que les exemples décrits en relation avec les figures 4, 5, 6, 7 et 8 correspondent à des dispositifs de couplage unidirectionnels, les modes de réalisation décrits ne se limitent pas à ce cas particulier. A titre de variante, l'homme du métier saura prévoir des dispositifs de couplage à isolation galvanique bidirectionnels basés sur des condensateurs à capacité variable à quatre électrodes à actionnement électrostatique, électromagnétique ou piézoélectrique. On notera en particulier que dans l'exemple de la figure 2, la tension appliquée entre les électrodes principales S et D du condensateur C influe sur la valeur de la capacité entre les électrodes de commande G et R du condensateur, ce qui permet la mise en oeuvre d'un couplage bidirectionnel.

## Revendications

1. Système comprenant des premier et deuxième circuits électriques ou électroniques isolés galvaniquement l'un de l'autre, et un dispositif de couplage (400 ; 500 ; 700) reliant le premier circuit au deuxième circuit, le dispositif de couplage comprenant un condensateur (C) à capacité variable comprenant des première (S) et deuxième (D) électrodes mobiles l'une par rapport à l'autre, séparées par une région isolante, et des troisième (G) et quatrième (R) électrodes isolées électriquement des première et deuxième électrodes, adaptées à recevoir un signal de commande (Ve, Ie) pour faire varier, par un mécanisme d'actionnement électrostatique, électromagnétique ou piézoélectrique, la position relative des première (S) et deuxième (D) électrodes, de façon à faire varier la capacité ($C_{SD}$) entre les première (S) et deuxième (D) électrodes,

   dans lequel le dispositif de couplage (400 ; 500 ; 700) comprend des première (e1) et deuxième (e2) bornes d'entrée connectées au premier circuit et adaptées à recevoir un signal d'entrée (Ve, Ie) provenant du premier circuit, et des première (s1) et deuxième (s2) bornes de sortie connectées au deuxième circuit et isolées galvaniquement des première et deuxième bornes d'entrée, adaptées à fournir au deuxième circuit un signal de sortie (Vs) image du signal d'entrée,

   et dans lequel les première (e1) et deuxième (e2) bornes d'entrée sont connectées respectivement aux troisième (G) et quatrième (R) électrodes du condensateur (C).

2. Système selon la revendication 1, dans lequel les première (s1) et deuxième (s2) bornes de sortie sont reliées aux première (S) et deuxième (D) électrodes du condensateur (C) de façon que le signal de sortie (Vs) varie en fonction de la valeur de la capacité ($C_{SD}$) entre les première (S) et deuxième (D) électrodes.

3. Système selon la revendication 1 ou 2, dans lequel le signal d'entrée (Ve) est un signal alternatif, le dispositif de couplage (400) comprenant un circuit adapté à appliquer une tension constante entre les première (S) et deuxième (D) électrodes du condensateur, et à fournir une tension proportionnelle au courant ($i_D$) produit sur la deuxième électrode (D) du condensateur du fait des variations de la capacité ($C_{SD}$) entre les première (S) et deuxième (D) électrodes du condensateur (C).

4. Système selon la revendication 3, dans lequel ledit circuit du dispositif de couplage (400) comprend :

   une source de tension (401) adaptée à appliquer une première tension continue constante ($V_{DC}$) sur la première électrode (S) du condensateur (C) ;

   un amplificateur opérationnel (403) dont l'entrée négative (-) est connectée à la deuxième électrode (D) du condensateur (C) ;

   une source de tension (405) adaptée à appliquer une deuxième tension continue constante ($V_{POL}$) sur l'entrée positive (+) de l'amplificateur opérationnel (403) ; et

   une résistance ($R_{IV}$) reliant l'entrée négative (-) de l'amplificateur opérationnel (403) à la sortie de l'amplificateur opérationnel (403).

5. Système selon la revendication 1 ou 2, dans lequel le signal d'entrée (Ve) est un signal alternatif ou continu, le dispositif de couplage (500 ; 700) comprenant un oscillateur (501) adapté à fournir une tension (Vs) dont la fréquence est fonction de la valeur de la capacité ($C_{SD}$) entre les première (S) et deuxième (D) électrodes du condensateur (C).

6. Système selon la revendication 5, dans lequel l'oscillateur (501) comprend un comparateur à hystérésis (601, R1, R2) agencé pour comparer la tension ($V_{SD}$) entre les première (S) et deuxième (D) électrodes du condensateur (C) à un premier seuil ($V_H$) et à un deuxième seuil ($V_L$) inférieur au premier seuil, et à commander l'application d'un courant de décharge (I-) constant entre les première (S) et deuxième (D) électrodes du condensateur (C) lorsque ladite tension atteint le premier seuil, et l'application d'un courant de charge (I+) constant entre les première (S) et deuxième (D) électrodes du condensateur lorsque ladite tension atteint le deuxième seuil.

7. Système selon la revendication 5 ou 6, dans lequel le dispositif de couplage (700) comprend en outre :

   un condensateur supplémentaire (C') à capacité variable comprenant des première (S) et deuxième (D) électrodes mobiles l'une par rapport à l'autre, séparées par une région isolante, et des troisième (G) et quatrième (R) électrodes isolées électriquement des première et deuxième électrodes, adaptées à recevoir un signal de commande (Ve, Ie) pour faire varier, par un mécanisme d'actionnement électrostatique, électromagnétique ou piézoélectrique, la position relative des première (S) et deuxième (D) électrodes de façon à faire varier la capacité ($C_{SD}$) entre ses première (S) et deuxième (D) électrodes ;
   une source de tension adaptée à appliquer une tension continue de référence ($V_{REF}$) entre les troisième (G) et quatrième (R) électrodes du condensateur supplémentaire (C') ;
   un oscillateur supplémentaire (501') adapté à fournir une tension (Vs') dont la fréquence est fonction de la valeur de la capacité ($C_{SD}$) entre les première (S) et deuxième (D) électrodes du condensateur supplémentaire (C') ; et
   une boucle à verrouillage de phase (PLL) adaptée à fournir un signal ($\Delta\phi$) représentatif de la différence de fréquence entre la tension (Vs) fournie par l'oscillateur (501) et la tension (Vs') fournie par l'oscillateur supplémentaire (501').

8. Système selon l'une quelconque des revendications 1 à 7, dans lequel le premier circuit est alimenté sous une tension au moins dix fois plus faible ou au moins dix fois plus élevée que le deuxième circuit.

9. Système selon l'une quelconque des revendications 1 à 8, dans lequel les première (S), deuxième (D), troisième (G) et quatrième (R) électrodes du condensateur (C) sont revêtues d'une couche en un matériau isolant.

10. Système selon la revendication 9, dans lequel ledit matériau isolant est du parylène.

**Patentansprüche**

1. System, das erste und zweite elektrische oder elektronische Schaltungen aufweist, die galvanisch voneinander isoliert sind, und eine Kopplungsvorrichtung (400; 500; 700), die die erste Schaltung mit der zweiten Schaltung koppelt, wobei die Kopplungsvorrichtung einen Kondensator (C) mit variabler Kapazität aufweist, der erste (S) und zweite (D) Elektroden aufweist, die bezüglich zueinander beweglich sind, getrennt durch einen Isolierbereich, und dritte (G) und vierte (R) Elektroden, die elektrisch von den ersten und zweiten Elektroden isoliert sind, die in der Lage sind, ein Steuersignal (Ve, Ie) zu empfangen, um durch einen elektrostatischen, elektromagnetischen oder piezoelektrischen Betätigungsmechanismus die relative Position der ersten (S) und zweiten (D) Elektroden zu variieren bzw. zu verändern, um die Kapazität ($C_{SD}$) zwischen der ersten (S) und der zweiten (D) Elektrode zu variieren, wobei die Kopplungsvorrichtung (400; 500; 700) erste (e1) und zweite (e2) Eingangsanschlüsse aufweist, die mit der ersten Schaltung verbunden sind und in der Lage sind, ein Eingangssignal (Ve, Ie) zu empfangen, das von der ersten Schaltung stammt, und erste (s1) und zweite (s2) Ausgangsanschlüsse, die mit der zweiten Schaltung verbunden und von den ersten und zweiten Eingangsanschlüssen galvanisch isoliert sind und in der Lage sind, die zweite Schaltung mit einem Ausgangssignal (Vs) zu versorgen, das ein Bild des Eingangssignals ist, und wobei die ersten (e1) und zweiten (e2) Eingangsanschlüsse jeweils mit den dritten (G) und vierten (R) Elektroden des Kondensators (C) verbunden sind.

2. System nach Anspruch 1, wobei die ersten (s1) und zweiten (s2) Ausgangsanschlüsse mit den ersten (S) und zweiten (D) Elektroden des Kondensators (C) gekoppelt sind, so dass das Ausgangssignal (Vs) entsprechend dem Wert der Kapazität ($C_{SD}$) zwischen den ersten (S) und zweiten (D) Elektroden variiert.

3. System nach Anspruch 1 oder 2, wobei das Eingangssignal (Ve) ein Wechselstromsignal ist, wobei die Kopplungsvorrichtung (400) eine Schaltung aufweist, die in der Lage ist, eine konstante Spannung zwischen den ersten (S) und zweiten (D) Elektroden des Kondensators anzulegen und eine Spannung zu liefern, die proportional zum Strom ($i_D$) ist, der an der zweiten Elektrode (D) des Kondensators aufgrund der Variationen der Kapazität ($C_{SD}$) zwischen den ersten (S) und zweiten (D) Elektroden des Kondensators (C) erzeugt wird.

4. System nach Anspruch 3, wobei die Schaltung der Kopplungsvorrichtung (400) Folgendes aufweist:

    eine Spannungsquelle (401), die in der Lage ist, eine erste konstante Gleichspannung ($V_{DC}$) an die erste Elektrode (S) des Kondensators (C) anzulegen;
    einen Operationsverstärker (403), dessen negativer Eingang (-) mit der zweiten Elektrode (D) des Kondensators (C) verbunden ist;
    eine Spannungsquelle (405), die in der Lage ist, eine zweite konstante Gleichspannung ($V_{POL}$) an den positiven Eingang (+) des Operationsverstärkers (403) anzulegen; und
    einen Widerstand ($R_{IV}$), der den negativen Eingang (-) des Operationsverstärkers (403) mit dem Ausgang des Operationsverstärkers (403) koppelt.

5. System nach Anspruch 1 oder 2, wobei das Eingangssignal (Ve) ein Wechsel- oder Gleichstromsignal ist, wobei die Kopplungsvorrichtung (500; 700) einen Oszillator (501) aufweist, der in der Lage ist, eine Spannung (Vs) mit einer Frequenz zu liefern, die eine Funktion des Wertes der Kapazität ($C_{SD}$) zwischen den ersten (S) und zweiten (D) Elektroden des Kondensators (C) ist.

6. System nach Anspruch 5, wobei der Oszillator (501) einen Hysterese-Komparator (601, R1, R2) aufweist, der angeordnet ist, um die Spannung ($V_{SD}$) zwischen den ersten (S) und zweiten (D) Elektroden des Kondensators (C) mit einem ersten Schwellenwert ($V_H$) und mit einem zweiten Schwellenwert ($V_L$) unter dem ersten Schwellenwert zu vergleichen, und um das Anlegen eines konstanten Entladestroms (I-) zwischen den ersten (S) und zweiten (D) Elektroden des Kondensators (C) anzuordnen, wenn die Spannung den ersten Schwellenwert erreicht, und das Anlegen eines konstanten Ladestroms (I+) zwischen den ersten (S) und zweiten (D) Elektroden des Kondensators anzuordnen, wenn die Spannung den zweiten Schwellenwert erreicht.

7. System nach Anspruch 5 oder 6, wobei die Kupplungsvorrichtung (700) ferner Folgendes aufweist:

    einen zusätzlichen Kondensator (C') mit variabler Kapazität, der erste (S) und zweite (D) Elektroden aufweist, die bezüglich zueinander beweglich sind, getrennt durch einen Isolierbereich, und dritte (G) und vierte (R) Elektroden, die elektrisch von den ersten und zweiten Elektroden isoliert sind und in der Lage sind, ein Steuersignal (Ve, Ie) zu empfangen, um durch einen elektrostatischen, elektromagnetischen oder piezoelektrischen Betätigungsmechanismus die relative Position der ersten (S) und zweiten (D) Elektroden zu verändern, um die Kapazität ($C_{SD}$) zwischen ihren ersten (S) und zweiten (D) Elektroden zu variieren;
    eine Spannungsquelle, die in der Lage ist, eine Gleichstrom-Referenzspannung ($V_{REF}$) zwischen den dritten (G) und vierten (R) Elektrode n des zusätzlichen Kondensators (C') anzulegen;
    einen zusätzlichen Oszillator (501'), der in der Lage ist, eine Spannung (Vs') mit einer Frequenz zu liefern, die eine Funktion des Wertes der Kapazität ($C_{SD}$) zwischen den ersten (S) und zweiten (D) Elektroden des zusätzlichen Kondensators (C') ist; und
    einen Phasenregelkreis (PLL), der in der Lage ist, ein Signal ($\Delta\phi$) zu liefern, das repräsentativ ist für die Frequenzdifferenz zwischen der vom Oszillator (501) gelieferten Spannung (Vs) und der von dem zusätzlichen Oszillator (501') gelieferten Spannung (Vs').

8. System nach einem der Ansprüche 1 bis 7, wobei die erste Schaltung unter einer Spannung betrieben wird, die wenigstens zehnmal kleiner oder wenigstens zehnmal größer als die der zweiten Schaltung ist.

9. System nach einem der Ansprüche 1 bis 8, wobei die ersten (S), zweiten (D), dritten (G) und vierten (R) Elektroden des Kondensators (C) mit einer Schicht aus einem Isoliermaterial beschichtet sind.

10. Vorrichtung nach Anspruch 9, wobei das Isoliermaterial Parylen ist.

**EP 3 439 142 B1**

**Claims**

1. A system comprising first and second electric or electronic circuits galvanically isolated from each other, and a coupling device (400; 500; 700) coupling the first circuit to the second circuit, the coupling device comprising a variable-capacitance capacitor (C) comprising first (S) and second (D) electrodes mobile with respect to each other, separated by an insulating region, and third (G) and fourth (R) electrodes electrically insulated from the first and second electrodes, capable of receiving a control signal (Ve, Ie) to vary, by an electrostatic, electromagnetic, or piezoelectric actuation mechanism, the relative position of the first (S) and second (D) electrodes, to vary the capacitance ($C_{SD}$) between the first (S) and second (D) electrodes,

   wherein the coupling device (400; 500; 700) comprises first (e1) and second (e2) input terminals connected to the first circuit and capable of receiving an input signal (Ve, Ie) originating from the first circuit, and first (s1) and second (s2) output terminals connected to the second circuit and galvanically isolated from the first and second input terminals, capable of supplying the second circuit with an output signal (Vs) which is an image of the input signal, and wherein the first (e1) and second (e2) input terminals are respectively connected to the third (G) and fourth (R) electrodes of the capacitor (C).

2. The system of claim 1, wherein the first (s1) and second (s2) output terminals are coupled to the first (S) and second (D) electrodes of the capacitor (C) so that the output signal (Vs) varies according to the value of the capacitance ($C_{SD}$) between the first (S) and second (D) electrodes.

3. The system of claim 1 or 2, wherein the input signal (Ve) is an AC signal, the coupling device (400) comprising a circuit capable of applying a constant voltage between the first (S) and second (D) electrodes of the capacitor, and of supplying a voltage proportional to the current ($i_D$) generated on the second electrode (D) of the capacitor due to the variations of the capacitance ($C_{SD}$) between the first (S) and second (D) electrodes of the capacitor (C).

4. The system of claim 3, wherein said circuit of the coupling device (400) comprises:

   a voltage source (401) capable of applying a first constant DC voltage ($V_{DC}$) onto the first electrode (S) of the capacitor (C) ;
   an operational amplifier (403) having its negative input (-) connected to the second electrode (D) of the capacitor (C);
   a voltage source (405) capable of applying a second constant DC voltage ($V_{POL}$) onto the positive input (+) of the operational amplifier (403); and
   a resistor ($R_{IV}$) coupling the negative input (-) of the operational amplifier (403) to the output of the operational amplifier (403).

5. The system of claim 1 or 2, wherein the input signal (Ve) is an AC or DC signal, the coupling device (500; 700) comprising an oscillator (501) capable of supplying a voltage (Vs) having a frequency which is a function of the value of the capacitance ($C_{SD}$) between the first (S) and second (D) electrodes of the capacitor (C).

6. The system of claim 5, wherein the oscillator (501) comprises a hysteresis comparator (601, R1, R2) arranged to compare the voltage ($V_{SD}$) between the first (S) and second (D) electrodes of the capacitor (C) with a first threshold ($V_H$) and with a second threshold ($V_L$) lower than the first threshold, and to order the application of a constant discharge current (I-) between the first (S) and second (D) electrodes of the capacitor (C) when said voltage reaches the first threshold, and the application of a constant charge current (I+) between the first (S) and second (D) electrodes of the capacitor when said voltage reaches the second threshold.

7. The system of claim 5 or 6, wherein the coupling device (700) further comprises:

   an additional variable-capacitance capacitor (C') comprising first (S) and second (D) electrodes mobile with respect to each other, separated by an insulating region, and third (G) and fourth (R) electrodes electrically insulated from the first and second electrodes, capable of receiving a control signal (Ve, Ie) to vary, by an electrostatic, electromagnetic, or piezoelectric actuation mechanism, the relative position of the first (S) and second (D) electrodes to vary the capacitance ($C_{SD}$) between its first (S) and second (D) electrodes;
   a voltage source capable of applying a DC reference voltage ($V_{REF}$) between the third (G) and fourth (R) electrodes of the additional capacitor (C');
   an additional oscillator (501') capable of supplying a voltage (Vs') having a frequency which is a function of the value of the capacitance ($C_{SD}$) between the first (S) and second (D) electrodes of the additional capacitor (C'); and

12

a phase-locked loop (PLL) capable of supplying a signal ($\Delta\phi$) representative of the frequency difference between the voltage (Vs) supplied by the oscillator (501) and the voltage (Vs') supplied by the additional oscillator (501').

8. The system of any of claims 1 to 7, wherein the first circuit is powered under a voltage which is at least ten times smaller or at least ten times greater than that of the second circuit.

9. The system of any of claims 1 to 8, wherein the first (S), second (D), third (G), and fourth (R) electrodes of the capacitor (C) are coated with a layer of an insulating material.

10. The device of claim 9, wherein said insulating material is parylene.

Fig 1

Fig 2

Fig 3

Fig 4

Fig 5

Fig 6

Fig 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2007236182 A
- WO 16204534 A
- EP 16204534
- FR 1755419
- EP 0986077 A
- US 6242989 B